# EUROPEAN PATENT APPLICATION

(11) **EP 4 393 733 A1**
(43) Date of publication of application: **03.07.2024**
(21) Application number: 23216042.4
(22) Date of filing: 12.12.2023
(51) Int. Cl.: B60H 1/32, B60H 1/00

(54) **REFRIGERATION SYSTEM FOR TRANSPORT REFRIGERATION VEHICLE AND HEAT DISSIPATION METHOD FOR ELECTRONIC COMPONENTS THEREIN**

(30) Priority: 16.12.2022 CN 202211620394
(71) Applicant: Carrier Corporation, Palm Beach Gardens, FL 33418 (US)
(72) Inventor: XIE, Kangshan, Shanghai, 201206 (CN); CHEN, Linhui, Shanghai, 201206 (CN); LI, Jie, Shanghai, 201206 (CN)
(74) Representative: Dehns

(57) **Abstract**

The present application provides a refrigeration system for transport refrigeration vehicles and a heat dissipation method for electronic components therein. The refrigeration system comprises: a main refrigeration circuit comprising a compressor (1), a condenser (2), a main throttling device (3), and an evaporator (4) that are sequentially connected, where the evaporator is configured to provide refrigeration to a storage compartment of the transport refrigeration vehicles; an electronic component heat dissipation circuit (5) configured to provide heat dissipation for electronic components; wherein, the electronic component heat dissipation circuit comprises an associated heat exchanger (52), in which refrigerant in the electronic component heat dissipation circuit exchanges heat with refrigerant from a first branch of the main refrigeration circuit, where the first branch extends from between the condenser (2) and the main throttling device (3) on the main refrigeration circuit, and is in communication with an EVI inlet (13) of the compressor (1) through a first throttling element (81) and the associated heat exchanger (52). The device and method according to the embodiments of the present invention can provide sufficient heat dissipation to the electronic component of transport refrigeration vehicles to cope with extreme ambient temperatures, with little impact on the main refrigeration circuit.

## Description

### FIELD OF THE INVENTION

The present invention relates to the field of transport refrigeration vehicles, in particular to a refrigeration system for transport refrigeration vehicles and a heat dissipation method for electronic components therein.

### BACKGROUND OF THE INVENTION

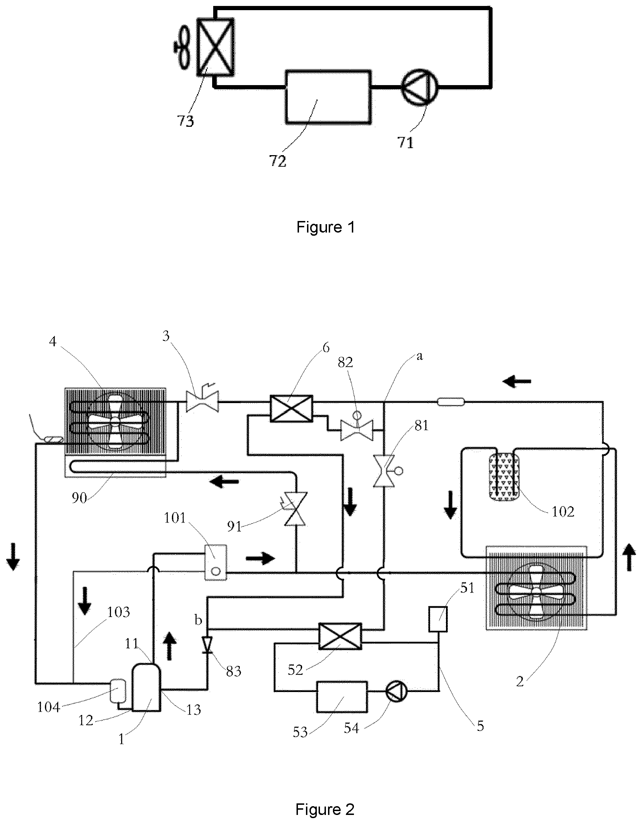

Transport refrigeration vehicles play a crucial role in cold-chain transportation. In recent years, transport refrigeration vehicles based on new energy have developed rapidly. Compared to transport refrigeration vehicles based on traditional fuel vehicles, there are more and more electronic components such as transformers and inverters on vehicles, so the demand for heat dissipation of electronic components is increasing. The previous heat dissipation method for electronic components was to use an electronic component heat dissipation circuit, as shown in FIG. 1, which includes a pump 71, an electronic component carrier 72, a radiator 73, and pipelines connecting them into a circuit. Water, as a cooling medium, transfers heat in the circuit and dissipates it to the environment through a fan-based radiator 73. The size of the radiator 73 needs to be designed to cope with extreme temperatures, such as high temperatures in summer. Therefore, as the heat dissipation demand increases, the size of the radiator 73 also continues to increase. For transport refrigeration vehicles, however, the space and load on the vehicle are both precious and limited.

### SUMMARY OF THE INVENTION

The object of at least an embodiment of the present application is to solve or at least alleviate the problems existing in the prior art.

According to a first aspect of the invention a refrigeration system for a transport refrigeration vehicle is provided, comprising:
a main refrigeration circuit comprising a compressor, a condenser, a main throttling element, and an evaporator that are sequentially connected, where the evaporator is configured to provide refrigeration to a storage compartment of the transport refrigeration vehicle;
an electronic component heat dissipation circuit configured to provide heat dissipation for an electronic component;
wherein, the electronic component heat dissipation circuit comprises an associated heat exchanger, in which cooling medium in the electronic component heat dissipation circuit exchanges heat with refrigerant from a first branch of the main refrigeration circuit, wherein the first branch extends from the main refrigeration circuit between the condenser and the main throttling device, and is in communication with an EVI (Enhanced Vapor Injection) inlet of the compressor through a first throttling element and the associated heat exchanger.

Optionally, the main refrigeration circuit further comprises: an economizer between the condenser and the main throttling device, and a second branch extending from the main refrigeration circuit between the condenser and the main throttling device and is in communication with the EVI inlet of the compressor through a second throttling element and the economizer.

Optionally, both the first branch and the second branch extend from upstream of the economizer, or, both the first branch and the second branch extend from downstream of the economizer, or, one of the first branch and the second branch extends from upstream of the economizer and the other extends from downstream of the economizer.

Optionally, the first throttling element and the second throttling element are electronic expansion valves, where opening of the first throttling element and the second throttling element is dynamically controlled based on the temperature of the electronic component.

Optionally, when the temperature of the electronic component is within a predetermined range, the opening of the first throttling element is increased while the opening of the second throttling element is reduced when the temperature of the electronic component increases, and the opening of the second throttling element is increased while the opening of the first throttling element is reduced when the temperature of the electronic component decreases.

Optionally, the first branch and the second branch merge together before being connected to the EVI inlet, where a check valve that only allows fluid to flow to the EVI inlet is provided on a flow path after the first branch and the second branch merge together.

Optionally, the electronic component heat dissipation circuit comprises a pump, an electronic component heat dissipation carrier, and an associated heat exchanger that are sequentially connected. Optionally, the electronic component heat dissipation circuit also comprises a radiator.

Optionally, the electronic component includes a transformer and/or an inverter for the compressor.

According to a second aspect of the invention there is provided a method for dissipating heat from an electronic component of a transport refrigeration vehicle is further provided, the method comprising:
branching a first part of refrigerant from a main refrigeration circuit between a condenser and a main throttling device;
throttling the first part of refrigerant through a first expansion valve;
bringing the first part of refrigerant after being throttled to exchange heat with cooling medium in an electronic component heat dissipation circuit; and
returning the first part of refrigerant to an EVI (Enhanced Vapor Injection) inlet of the compressor.

Optionally, the method further comprises:
branching a second part of refrigerant from the main refrigeration circuit between the condenser and the main throttling device;
throttling the second part of refrigerant through a second expansion valve;
bringing the second part of refrigerant after being throttled to exchange heat with remaining refrigerant in the main circuit;
returning the second part of refrigerant to the EVI inlet of the compressor; and
wherein, opening of the first expansion valve and the second expansion valve is controlled based on the temperature of the electronic component.

The device and method according to the embodiments of the present invention can provide sufficient heat dissipation to the electronic component of transport refrigeration vehicles to cope with extreme ambient temperatures, with substantially no impact on the main refrigeration circuit.

### BRIEF DESCRIPTION OF THE DRAWINGS

With reference to the accompanying drawings, the disclosure of the present application will become easier to understand. Those skilled in the art would easily understand that these drawings are for the purpose of illustration, and are not intended to limit the protection scope of the present application, which is as set out in the appended claims. Furthermore, in the figures, similar numerals are used to denote similar components.

Certain exemplary embodiments will now be described in greater detail by way of example only and with reference to the accompanying drawings in which:
FIG. 1 shows an electronic component heat dissipation circuit commonly used in transport refrigeration vehicles;
FIG. 2 shows a refrigeration system of transport refrigeration vehicles; and
FIG. 3 shows another refrigeration system of transport refrigeration vehicles.

### DETAILED DESCRIPTION

Referring to FIG. 2, a refrigeration system of transport refrigeration vehicles according to an embodiment of the present invention is shown, which includes a main refrigeration circuit and an electronic component heat dissipation circuit. The main refrigeration circuit includes a compressor 1, a condenser 2, a main throttling element 3, and an evaporator 4 that are sequentially connected, where the evaporator 4 is used to provide refrigeration (or optionally heating) to the storage compartment of a transport refrigeration vehicle, so as to maintain the storage compartment within a predetermined temperature range. In the main refrigeration circuit, the compressor 1 is an Enhanced Vapor Injection (EVI) compressor, which includes: an air inlet 12, an air outlet 11, and an EVI inlet 13. The main throttling element 3 can be a thermal expansion valve or an electronic expansion valve. In the embodiment shown, a gas-liquid separator 104 is arranged upstream of the air inlet 12 of the compressor 1, and an oil separator 101 can be arranged downstream of the air outlet 11 of the compressor 1. The separated oil is sent back to the air inlet 12 of the compressor through a pipeline 103, and the compressed gas is delivered to the condenser 2. The fluid passing through the condenser 2 and then passing through a reservoir 102 returns to the subcooling circuit of the condenser 2 for further cooling and heat exchanging, then is throttled at the main throttling device 3, passing through the evaporator 4 and returning to the air inlet 12 of the compressor. In the embodiment shown, the main refrigeration circuit also includes a defrosting branch 90, which includes a control valve 91. When the evaporator 4 frosts, the control valve 91 is opened to guide the steam from the compressor outlet to the bottom of the evaporator 4, and then into the respective conduits of the evaporator through a distributor to remove frost on the surface of the evaporator 4.

The electronic component heat dissipation circuit 5 is used to provide heat dissipation for electronic components, such as transformers and/or an inverter for the compressor, or other electronic components on the vehicle that require heat dissipation. In the case of electric vehicles, for example, it can mean to provide heat dissipation for power batteries and related components. The heat dissipation circuit 5, adopts, for example, a water cooling form, such as using a water jacket in thermal association with the electronic component, thereby dissipating heat on the electronic component through the cooling medium, which can be water or other suitable liquids. An associated heat exchanger 52 is included in the electronic component heat dissipation circuit. In the associated heat exchanger 52, the cooling medium in the electronic component heat dissipation circuit 5 exchanges heat with the refrigerant from a first branch of the main refrigeration circuit. The first branch extends from the main refrigeration circuit between the condenser 2 and the main throttling device 3, such as from position a upstream of the economizer 6 in FIG. 2, and the first branch is in communication with the EVI inlet 13 of the compressor through the first throttling element 81 and the associated heat exchanger 52. Through this arrangement, the refrigerant in the main refrigeration circuit can be used to exchange heat with the cooling medium in the electronic component heat dissipation circuit 5, thereby helping electronic components dissipate heat and providing a cooling capacity margin.

In some embodiments, the main refrigeration circuit further includes: an economizer 6 between the condenser 2 and the main throttling device 3, and a second branch extending from the main refrigeration circuit between the condenser 2 and the main throttling device 3. In the embodiment shown in FIG. 2, the second branch extends from position a upstream of the economizer 6, and the second branch is in communication with the EVI inlet 13 of the compressor through the second throttling element 82 and the economizer 6. In the main refrigeration circuit, the arrangement of the economizer 6 and the second branch (economizer branch) can increase the subcooling of the refrigerant before the throttling of the main throttling device 3, thereby improving the system capacity.

In some embodiments, the first throttling element 81 and the second throttling element 82 are electronic expansion valves, and the opening of the first throttling element 81 and the second throttling element 82 is dynamically controlled based on the temperature of the electronic component. The specific control concept is to increase the refrigerant passing through the first branch when the temperature of the electronic component is relatively high and more heat dissipation is required, and to increase the refrigerant passing through the second branch or even close the first throttling element 81 when the temperature of the electronic component is relatively low and no more heat dissipation is required. Therefore, in some embodiments, when the temperature of the electronic component is within a predetermined range, such as between T1 to T2, the refrigeration system can be configured to increase the opening of the first throttling element 81 and reduce the opening of the second throttling element 82 when the temperature of the electronic component increases, and to increase the opening of the second throttling element 82 and reduce the opening of the first throttling element 81 when the temperature of the electronic component decreases. In some embodiments, if the temperature of the electronic component is lower than a predetermined temperature, such as T1, the first throttling element 81 can be kept closed. Furthermore, in some embodiments, the opening of the first throttling element 81 and the second throttling element 82 can also be controlled based on the ambient temperature. As the compressor operates at a certain frequency, the flow rate of the EVI inlet 13 of the compressor is constant. Therefore, as long as it is ensured that the first throttling element 81 and the second throttling element 82 are not closed at the same time, the refrigerant flow passing through the first and second branches can be allocated through the opening of the first throttling element 81 and the second throttling element 82, where this allocation has little impact on the main refrigeration circuit. In some embodiments, the first and second branches merge at, for example, position b, before being connected to the EVI inlet 13, where a check valve 83 that only allows fluid to flow to the EVI inlet 13 is arranged in the flow path after the merging of the first and second branches. In alternative embodiments, the first and second branches can be respectively provided with check valves before merging, or the first and second branches can be connected to the EVI inlet 13 of the compressor, respectively.

In some embodiments, the electronic component heat dissipation circuit 5 may include a pump 54, an electronic component heat dissipation carrier 53, and an associated heat exchanger 52 that are sequentially connected, and an optional expansion tank 51 may also be provided to accommodate extra cooling medium. The electronic component heat dissipation carrier 53 can be, for example, water pipes, water jacket, or the like that is in thermal association with the electronic component.

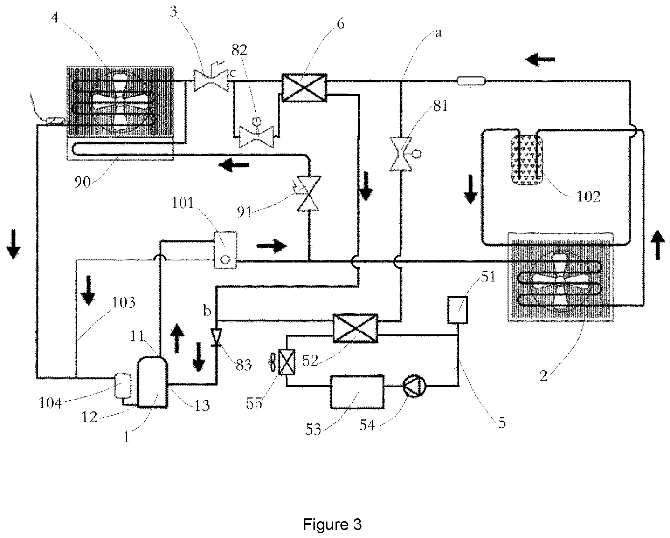

With continued reference to FIG. 3, alternative embodiments according to the present invention are described. In the embodiment shown in FIG. 2, both the first and second branches extend from position a upstream of the economizer. In the embodiment shown in FIG. 3, the first branch extends from position a upstream of the economizer, while the second branch extends from position c downstream of the economizer. In further embodiments, it can be conceived that the first branch extends from position c downstream of the economizer, while the second branch extends from position a upstream of the economizer, or, both the first and second branches extend from position c downstream of the economizer.

In the embodiment of FIG. 3, the electronic component heat dissipation circuit 5 further includes a radiator 55, which is configured to cope with normal heat dissipation demands, such as the heat dissipation demands in winter, spring, and autumn, while the associated heat exchanger 52 is used to cope with extreme heat dissipation demands when the ambient temperature is relatively high, such as the heat dissipation demands in summer. Therefore, the first branch 81 is closed in normal conditions, and is only activated at extreme temperatures, where such arrangement makes it possible to select a more compact radiator as the radiator 55.

A method for dissipating heat from electronic components of transport refrigeration vehicles is further provided, the method comprising: branching a first part of refrigerant from a main refrigeration circuit between a condenser and a main throttling device; throttling the first part of refrigerant through a first expansion valve; bringing the first part of refrigerant after being throttled to exchange heat with cooling medium in an electronic component heat dissipation circuit; and returning the first part of refrigerant to an EVI inlet of a compressor.

In some embodiments, the method further comprises: branching a second part of refrigerant from the main refrigeration circuit between the condenser and the main throttling device; throttling the second part of refrigerant through a second expansion valve; bringing the second part of refrigerant after being throttled to exchange heat with remaining refrigerant in the main circuit; and returning the second part of refrigerant to the EVI inlet of the compressor; and wherein, the opening of the first expansion valve and the second expansion valve is controlled based on the temperature of the electronic component.

In some embodiments, the method further comprises: when the temperature of the electronic component is within a predetermined range, increasing the amount of the first part of refrigerant and reducing the amount of the second part of refrigerant when the temperature of the electronic component increases, and increasing the amount of the second part of refrigerant and reducing the amount of the first part of refrigerant when the temperature of the electronic component decreases. In some embodiments, when the temperature of the electronic component is lower than a predetermined temperature, the first part of refrigerant is cut off. Furthermore, in some embodiments, the amounts of the first and second parts of refrigerant can also be regulated based on the ambient temperature.

The device and method according to the present invention utilizes a part of refrigerant in the economizer branch of the main refrigeration circuit to dissipate heat from the electronic component. This can meet the heat dissipation demands of electronic components under extreme ambient temperatures and does not affect the refrigerant flow passing through the evaporator in the main refrigeration circuit, thus ensuring the refrigeration capacity of the main refrigeration circuit.

The specific embodiments described above in the present application are merely intended to describe the principles of the present application more clearly, wherein various components are clearly shown or described to facilitate the understanding of the principles of the present invention as set out in the appended clams. Those skilled in the art may, without departing from the scope of the present invention as set out in the appended claims, make various modifications or changes to the present application. Therefore, it should be understood that these modifications or changes should be included within the scope of patent protection of the present invention, which is as set out in the appended claims.

## Claims

1. A refrigeration system for a transport refrigeration vehicle, comprising:
a main refrigeration circuit comprising a compressor (1), a condenser (2), a main throttling device (3), and an evaporator (4) that are sequentially connected, wherein the evaporator (4) is configured to provide refrigeration to a storage compartment of the transport refrigeration vehicle;
an electronic component heat dissipation circuit (5) configured to provide heat dissipation for an electronic component;
wherein, the electronic component heat dissipation circuit (5) comprises an associated heat exchanger (52), in which cooling medium in the electronic component heat dissipation circuit (5) exchanges heat with refrigerant from a first branch of the main refrigeration circuit, wherein the first branch extends from the main refrigeration circuit between the condenser (2) and the main throttling device (3), and is in communication with an EVI inlet (13) of the compressor (1) through a first throttling element (81) and the associated heat exchanger (52).

2. The refrigeration system according to claim 1, wherein the main refrigeration circuit further comprises: an economizer (6) between the condenser (2) and the main throttling device (3), and a second branch extending from the main refrigeration circuit between the condenser (2) and the main throttling device (3), where the second branch is in communication with the EVI inlet (13) of the compressor (1) through a second throttling element (82) and the economizer (6).

3. The refrigeration system according to claim 2, wherein both the first branch and the second branch extend from upstream of the economizer (6), or, both the first branch and the second branch extend from downstream of the economizer (6), or, one of the first branch and the second branch extends from upstream of the economizer (6) and the other extends from downstream of the economizer (6).

4. The refrigeration system according to claim 2 or 3, wherein the first throttling element (81) and the second throttling element (82) are electronic expansion valves, and opening of the first throttling element (81) and the second throttling element (82) is dynamically controlled based on temperature of the electronic component.

5. The refrigeration system according to claim 4, wherein when the temperature of the electronic component is within a predetermined range, opening of the first throttling element (81) is increased while opening of the second throttling element (82) is reduced when the temperature of the electronic component increases, and opening of the second throttling element (82) is increased while opening of the first throttling element (81) is reduced when the temperature of the electronic component decreases.

6. The refrigeration system according to any of claims 2 to 5, wherein the first branch and the second branch merge together before being connected to the EVI inlet (13), where a check valve (83) that only allows fluid to flow to the EVI inlet (13) is provided on a flow path after the first branch and the second branch merge together.

7. The refrigeration system according to any preceding claim, wherein the electronic component heat dissipation circuit (5) comprises a pump (54), an electronic component heat dissipation carrier (53), and the associated heat exchanger (52) that are sequentially connected, and optionally, the electronic component heat dissipation circuit further (5) comprises an expansion tank (51) and a radiator (55).

8. The refrigeration system according to any preceding claim, wherein the electronic component includes a transformer and/or an inverter for the compressor (1).

9. A method for dissipating heat from an electronic component of a transport refrigeration vehicle, comprising:
branching a first part of refrigerant from a main refrigeration circuit between a condenser (2) and a main throttling device (3);
throttling the first part of refrigerant through a first expansion valve (81);
bringing the first part of refrigerant after being throttled to exchange heat with cooling medium in an electronic component heat dissipation circuit (5); and
returning the first part of refrigerant to an EVI inlet (13) of a compressor (1).

10. The method according to claim 9, further comprising:
branching a second part of refrigerant from the main refrigeration circuit between the condenser (2) and the main throttling device (3);
throttling the second part of refrigerant through a second expansion valve (82);
bringing the second part of refrigerant after being throttled to exchange heat with remaining refrigerant in the main circuit;
returning the second part of refrigerant to the EVI inlet (13) of the compressor (1); and
wherein, opening of the first expansion valve (81) and the second expansion valve (82) is controlled based on temperature of the electronic component.
